# EUROPÄISCHE PATENTANMELDUNG

(11) **EP 4 682 657 A1**
(43) Veröffentlichungstag der Anmeldung: **21.01.2026**
(21) Anmeldenummer: 24189753.7
(22) Anmeldetag: 19.07.2024
(51) Int. Cl.: G05B 19/418, G05B 17/02, G06F 30/00

(54) **VERFAHREN ZUR COMPUTER-GESTÜTZTEN ERSTELLUNG EINER PLANUNG**

(71) Anmelder: Murrelektronik GmbH, 71570 Oppenweiler (DE)
(72) Erfinder: Pfestorf, Sebastian, 71570 Oppenweiler (DE); Zeller, Paul, 74223 Flein (DE); Binder, Sven, 71522 Backnang (DE)
(74) Vertreter: Bösherz Goebel Patentanwälte

(57) **Zusammenfassung**

Die Erfindung betrifft ein Verfahren (100) zur computer-gestützten Erstellung einer Planung für eine industrielle Anlage (300) mittels einer Softwareplattform (10), aufweisend:
- Empfangen (101) einer Benutzereingabe (25) über wenigstens eine Benutzerschnittstelle (20) der Softwareplattform (10),
- Zuordnen (102) der Benutzereingabe (25) zu einem Kontext (210) einer Anlagenplanung (200), durch welche zumindest ein Teil der industriellen Anlage (300) geplant wird,
- Verarbeiten (103) der Benutzereingabe (25) durch ein Assistenzmodul (50), wobei eine Antwort (55) des Assistenzmoduls (50) auf Basis der Benutzereingabe (25) und unter Berücksichtigung des Kontextes (210) generiert wird, wobei die Antwort (55) eine Gestaltung und/oder eine Umgestaltung und/oder eine Erweiterung und/oder eine Bewertung zumindest eines Teils der Anlagenplanung (200) spezifiziert,
- Initiieren (104) einer Ausgabe (26) der Antwort (55) an den Benutzer über die wenigstens eine Benutzerschnittstelle (20).

## Beschreibung

Die vorliegende Erfindung betrifft ein Verfahren zur computer-gestützten Erstellung einer Planung. Ferner bezieht sich die Erfindung auf ein Computerprogramm sowie eine Vorrichtung zu diesem Zweck.

Es ist aus dem Stand der Technik bekannt, dass durch Planungstools für industrielle Anlagen bereits viele Schritte bei der Anlagenplanung automatisiert werden können.

Nachteilhaft bei den bekannten Lösungen ist allerdings, dass die Bedienung und Interaktion mit solchen Planungstools oft kompliziert und aufwendig sind. Darüber hinaus ist der Funktionsumfang noch teilweise beschränkt oder es mangelt an automatisierten Funktionen für besondere Umstände und Bedingungen bei dem Einsatz von Anlagen.

Es ist daher eine Aufgabe der vorliegenden Erfindung, die voranstehend beschriebenen Nachteile zumindest teilweise zu beheben. Insbesondere ist es Aufgabe der vorliegenden Erfindung, eine verbesserte Softwareplattform zur computer-gestützten Erstellung einer Planung für eine industrielle Anlage bereitzustellen.

Gegenstand der Erfindung ist ein Verfahren mit den Merkmalen des Anspruchs 1, ein Computerprogramm mit den Merkmalen des Anspruchs 18 sowie eine Vorrichtung mit den Merkmalen des Anspruchs 19. Weitere Merkmale und Details der Erfindung ergeben sich aus den jeweiligen Unteransprüchen, der Beschreibung und den Zeichnungen. Dabei gelten Merkmale und Details, die im Zusammenhang mit dem erfindungsgemäßen Verfahren beschrieben sind, selbstverständlich auch im Zusammenhang mit dem erfindungsgemäßen Computerprogramm sowie der erfindungsgemäßen Vorrichtung, und jeweils umgekehrt, so dass bezüglich der Offenbarung der Erfindung stets auch eine wechselseitige Bezugnahme möglich ist.

Gegenstand der Erfindung ist insbesondere ein Verfahren zur computer-gestützten Erstellung einer Planung für eine industrielle Anlage mittels einer Softwareplattform.

Gemäß dem erfindungsgemäßen Verfahren kann ein Empfangen einer Benutzereingabe über wenigstens eine Benutzerschnittstelle der Softwareplattform vorgesehen sein. Die wenigstens eine Benutzerschnittstelle umfasst bspw. eine Softwareschnittstelle zu einem Human-Machine-Interface wie einer Tastatur oder einem Touchscreen, um Text- oder Toucheingaben zu erfassen. Weiter kann die wenigstens eine Benutzerschnittstelle auch eine Softwareschnittstelle zu einem Bildschirm und/oder Lautsprecher umfassen, um eine visuelle und/oder akustische Ausgabe zu ermöglichen.

Ferner kann das erfindungsgemäße Verfahren umfassen, dass eine Zuordnung der Benutzereingabe zu einem Kontext einer Anlagenplanung, durch welche zumindest ein Teil der industriellen Anlage geplant wird, erfolgt. Der Kontext wird nachfolgend auch als "zugeordneter Kontext" bezeichnet. Anschließend kann eine Verarbeitung der Benutzereingabe durch ein Assistenzmodul vorgesehen sein. Dabei kann eine Antwort des Assistenzmoduls auf Basis der Benutzereingabe und unter Berücksichtigung des zugeordneten Kontextes generiert werden. Weiterhin kann die Antwort eine Gestaltung und/oder eine Umgestaltung und/oder eine Erweiterung und/oder eine Bewertung zumindest eines Teils der Anlagenplanung spezifizieren. Sodann kann eine Ausgabe der Antwort an den Benutzer über die wenigstens eine Benutzerschnittstelle initiiert werden.

Die industrielle Anlage, oder auch Industrieanlage bezeichnet, kann z. B. eine elektrische und/oder mechanische und/oder pneumatische und/oder hydraulische und/oder fluidtechnische Anlage sein und entsprechend elektrische und/oder mechanische und/oder pneumatische und/oder hydraulische und/oder fluidtechnische Komponenten aufweisen. Entsprechend kann die Softwareplattform die Planung einer Vielzahl von verschiedenen Anlagentypen unterstützen. Die Vielfalt der Anlagentypen und deren jeweilige Ausstattung ermöglicht eine breite Palette an Einsatzmöglichkeiten in verschiedenen industriellen Sektoren. Beispielsweise:
- Elektrische Anlagen: Diese umfassen typischerweise Komponenten wie Motoren, Fördersysteme oder Roboter, Schalt- und Steuerungsanlagen. Diese Anlagen sind häufig für Automatisierungsprozesse vorgesehen und steuern bspw. diverse mechanische Abläufe in der Produktion, Verpackung und anderen industriellen Anwendungen.
- Mechanische Anlagen: Zu diesen gehören bspw. Maschinen und Geräte, die mechanische Arbeit verrichten, wie Pumpen, Kompressoren, Ventilatoren und Getriebe. Sie sind essenziell in Branchen wie der Fertigungsindustrie, Automobilproduktion oder auch in der Lebensmittelverarbeitung.
- Pneumatische Anlagen: Diese nutzen komprimierte Luft zur Energieübertragung und Steuerung von Maschinen. Typische Anwendungen finden sich in der Automatisierungstechnik, Montagelinien oder bei Verpackungsmaschinen.
- Hydraulische Anlagen: Sie verwenden Flüssigkeiten zur Kraftübertragung und finden z. B. in der Luftfahrttechnik oder in Pressen der Metallverarbeitung Anwendung.
- Fluidtechnische Anlagen: Diese sind bspw. spezialisiert auf die Handhabung von Flüssigkeiten und Gasen, einschließlich Filtration, Chemikaliendosierung und Flüssigkeitstransport. Einsatzgebiete umfassen die chemische Industrie, Wasseraufbereitungsanlagen und Raffinerien.

Jeder dieser Anlagentypen muss bei der Anlagenplanung ggf. spezifisch an die Umgebungsbedingungen und die funktionalen Anforderungen des Einsatzortes angepasst werden, um eine optimale Leistung und Sicherheit zu gewährleisten.

Zur Anlagenplanung ist häufig ein 3D-Modell (MCAD) ein Ausgangspunkt, welches bereits generisch, also gattungsgemäß, die Komponenten für die Anlage spezifiziert. Auf dieser Basis wird dann ein konkretisierter Anlagenplan, insbesondere Schalt- und/oder Verbindungs- und/oder Anschluss- und/oder Kabelplan und/oder dergleichen, erstellt. Der konkretisierte Anlagenplan umfasst somit die konkreten Komponenten, welche z. B. durch eine Betriebsmittelkennzeichnung und/oder Artikelkennzeichnung und/oder Herstellerkennzeichnung und/oder Serienkennzeichnung bezeichnet werden können. Auf dieser Basis kann eine detaillierte Ausarbeitung der Planung erfolgen, die alle erforderlichen Spezifikationen und Modifikationen umfasst, um die Anlage optimal an die gegebenen Bedingungen anzupassen.

Der konkretisierte Anlagenplan kann durch detaillierte Spezifikationen der Komponenten ergänzt werden, die vorzugsweise hinsichtlich ihrer Leistungsfähigkeit, Kompatibilität und Umweltbeständigkeit sorgfältig ausgewählt werden müssen. Die Implementierung von Sicherheitsmaßnahmen, wie beispielsweise Schutzvorrichtungen und Fehlererkennungssysteme, kann ebenfalls berücksichtigt werden, um die Integrität der Anlage und die Sicherheit der Bediener zu gewährleisten. Diese Auswahl der Komponenten wird herkömmlicherweise manuell durchgeführt und kann vorzugsweise durch das erfindungsgemäße Verfahren automatisiert vorgenommen und/oder durch wenigstens eine Planungsoption vorgeschlagen werden und/oder durch die Antwort ausgegeben werden.

Weiterhin sind in der Planungsphase weitere, nachfolgend genannte, Planungsschritte erforderlich, welche ggf. ebenfalls durch das erfindungsgemäße Verfahren durch die Verarbeitung vorgenommen und/oder durch die Antwort zumindest teilweise ausgegeben werden können. So können in der Planungsphase bspw. Installationsrouten und Wartungszugänge präzise definiert werden, um eine effiziente Montage und zukünftige Instandhaltung zu ermöglichen. Der abschließende Plan kann zudem umfassende Dokumentationen, wie Montageanleitungen und Betriebshandbücher, enthalten, die alle notwendigen Informationen für die Inbetriebnahme und den laufenden Betrieb der Anlage bieten. Jede Komponente kann ferner bei der Anlagenplanung durch eindeutige Kennzeichnungen wie Betriebsmittel-, Artikel-, Hersteller- oder Seriennummern identifizierbar gemacht werden, was auch die Rückverfolgbarkeit und Standardisierung im Einkauf und in der Lagerhaltung erheblich verbessert.

Der Begriff "Kontext" bezieht sich insbesondere auf die spezifischen Umstände und Bedingungen, die für die Planung und den Betrieb einer Anlage relevant sind. Somit umfasst der "Kontext" vorzugsweise mindestens einen der folgenden Aspekte:
- einen industriellen Kontext, in dem die Anlage betrieben wird, insbesondere einschließlich der branchenspezifischen Anforderungen und Standards,
- eine unmittelbare Umgebung der Anlage, insbesondere bezüglich relevanter Umgebungsbedingungen wie Feuchtigkeit und Sicherheitsrisiken. Dies umfasst bspw. den Einsatz von explosionsgefährlichen Stoffen oder die Notwendigkeit einer speziellen Abschirmung gegen Umwelteinflüsse,
- spezifische Anwendungsanforderungen der Anlage, beispielsweise die Eignung für den Einsatz in Schleppketten oder die Verwendung von spritzwassergeschützten Komponenten,
- mindestens eine spezifische Umgebungsbedingung, die den Betrieb der Anlage beeinflusst, wie hohe Feuchtigkeit, Vibrationen, Ölbelastung oder allgemeine Verschmutzung,
- Umgebungsdaten, die für die Konfiguration und Optimierung der Anlage erforderlich sind, insbesondere einschließlich Temperatur, Luftfeuchtigkeit und Druck,
- das Vorhandensein von bereits installierten Systemen und deren Spezifikationen, beispielsweise Busprotokolle oder andere Kommunikationsschnittstellen, die für den Aufbau und/oder die Integration der Anlage relevant sind.

Vorteilhafterweise kann die empfangene Benutzereingabe von einem Algorithmus zur automatischen Generierung von Planungsoptionen und/oder Anlagenplänen verarbeitet werden. Der Algorithmus kann dabei ggf. eine Datenbank mit gespeicherten Anlagenkomponenten und deren Eigenschaften nutzen. Auf Basis der verarbeiteten Benutzereingabe und ggf. der Datenbank sowie des Kontexts kann ein Anlagenplan generiert werden, der die gewünschten Anlagenkomponenten und deren Anordnung enthält. Der generierte Anlagenplan kann anschließend über die Benutzerschnittstelle der Softwareplattform ausgegeben und vorzugsweise von einem Anlagenplaner weiterbearbeitet werden.

Die vorgeschlagene Softwareplattform ermöglicht es, Benutzereingaben effizient zu verarbeiten und darauf basierend Antworten zu generieren. Diese Antworten können die Gestaltung, Umgestaltung und/oder Erweiterung von Planungen für industrielle Anlagen umfassen, bei welchen der Kontext der Anlageplanung berücksichtigt worden ist. Die Softwareplattform bietet damit interaktive Hilfestellungen und Rückmeldungen an einen Planer, um Planungsprozesse zu automatisieren und/oder zu optimieren. Darüber hinaus kann durch die automatische Berücksichtigung des Kontextes eine Erhöhung der Zuverlässigkeit und eine Vereinfachung der Planung ermöglicht werden.

Optional kann es vorgesehen sein, dass das Assistenzmodul ein Large Language Model umfasst, wobei das Large Language Model vorzugsweise dafür ausgeführt ist, mittels eines vortrainierten, tiefen neuronalen Netzwerks kontextbezogene Antworten basierend auf der Benutzereingabe zu generieren. Durch die Integration eines großen Sprachmodells (auf Englisch Large Language Model, oder kurz LLM) kann eine effiziente und kontextsensitive Kommunikation und Interaktion zwischen dem Benutzer und der Softwareplattform ermöglicht werden. Die Verwendung eines LLMs kann die Effizienz der Interaktion erheblich steigern, indem es eine natürlichere und intuitivere Art der Kommunikation ermöglicht. Zusätzlich kann das Modell ggf. so ausgeführt sein, dass es die Planung der Anlage zumindest teilweise automatisiert und/oder optimiert, wodurch die Anlagenplanung effizienter gestaltet wird.

Es ist möglich, dass das Assistenzmodul das LLM, insbesondere in der Form eines Sprachmodells, aufweist, welches auf einem Datensatz von Industriesystemen und ihren entsprechenden Plänen trainiert worden ist. Alternativ oder zusätzlich ist es denkbar, dass die Verarbeitung eine Verwendung eines durch künstliche Intelligenz gesteuerten Empfehlungssystems umfasst, um auf Basis der Benutzereingabe eine Änderung oder Gestaltung der Anlagenplanung vorzuschlagen.

Ferner ist es möglich, dass die Softwareplattform eine Wissensgraphen-Komponente zum Speichern von Informationen über elektrische Industriesysteme, ihre Komponenten und ihre entsprechenden Pläne oder Schemata aufweist, die von dem Assistenzmodul zum Erzeugen von Antworten verwendet wird.

Darüber hinaus ist es optional vorgesehen, dass für die Anlagenplanung in Planungsdaten, bspw. in einer Planungsdatei, insbesondere in einem 3D-Modell, die für den Kontext relevanten Komponenten gefunden werden. Dies können z. B. alle elektrischen Komponenten sein. Die relevanten Komponenten können dabei eindeutig identifiziert und bezeichnet werden, also bspw. eine eindeutige oder eineindeutige Kennzeichnung erhalten. Sodann kann automatisiert auf Basis dieser Planungsdaten und der jeweiligen Kennzeichnung eine Topologie für die Anlage erstellt werden. Hierbei können auf Basis von generischen Vorgaben von Komponenten durch die Planungsdaten konkrete Komponenten ausgewählt werden, die für die Anwendung relevant sind. Um diese Auswahl vorzunehmen, kann die Benutzereingabe und der Kontext ausgewertet werden. Auf diese Weise kann ein Output generiert werden, der ein nachvollziehbares Ergebnis zwischen Input (wie den Planungsdaten bzw. dem 3D Modell) und Output (z. B. der Topologie bzw. einem elektrischen Schaltplan) mit durchgängig zuordenbaren Komponenten umfasst.

Ein weiterer Vorteil im Rahmen der Erfindung ist erzielbar, wenn die Antwort eine Planungsoption, vorzugsweise erste oder alternative Planungsoption, vorschlägt, die wenigstens einem Kriterium, insbesondere wenigstens einer Bedingung und/oder wenigstens einer Einschränkung und/oder wenigstens einem Umstand und/oder wenigstens einem Bedürfnis, entspricht, welches durch die Benutzereingabe und/oder durch den Kontext spezifiziert wird. Dies hat den Vorteil, dass die Softwareplattform durch die automatisierte Generierung von Planungsoptionen, die auf spezifischen Kriterien basieren, eine effizientere und benutzerfreundlichere Anlagenplanung ermöglicht. Die Softwareplattform kann schnell und präzise auf die spezifischen Anforderungen für die geplante Anlage und ggf. auch auf individuelle Bedürfnisse reagieren, was die Planungszeit verkürzt, und die Qualität der Ergebnisse verbessert.

Weiter ist es von Vorteil, wenn die Antwort nicht nur eine einzige Lösung vorschlägt, sondern auch weitere alternative Planungsoptionen bereitstellt. Dadurch kann der Benutzer zwischen verschiedenen möglichen Lösungen wählen und die beste Option auswählen, die seinen spezifischen Anforderungen entspricht.

Des Weiteren kann vorgesehen sein, dass die Antwort die Gestaltung, insbesondere Neugestaltung und/oder einen Erstvorschlag für die Gestaltung, zumindest eines Teils der Anlagenplanung spezifiziert, und vorzugsweise hierzu auf Basis der verarbeiteten Benutzereingabe und des zugeordneten Kontextes eine Planungsoption vorschlägt. Dabei kann die Planungsoption eine Anpassung einer technischen Spezifikation und/oder Positionierung und/oder Auswahl von Komponenten bei der Anlagenplanung bereitstellt, insbesondere vorschlagen. Die Automatisierung der Planung durch die Erzeugung eines Vorschlags für die Gestaltung kann die Effizienz bei der Anlagenplanung deutlich steigern. Die Berücksichtigung des Kontextes kann dabei die Anpassungsfähigkeit an verschiedene Kriterien für die Anlage erhöhen. Die intuitive Kommunikation über die Benutzerschnittstelle mittels eines Frage- und Antwortdialogs kann es ferner dem Benutzer erleichtern, die Planung vorzunehmen und Anforderungen zu kommunizieren.

Nach einer weiteren Möglichkeit kann vorgesehen sein, dass die Antwort dadurch die Umgestaltung zumindest eines Teils der Anlagenplanung spezifiziert, dass sie auf Basis der verarbeiteten Benutzereingabe und des zugeordneten Kontextes eine alternative Planungsoption vorschlägt. Hierbei kann die alternative Planungsoption eine Anpassung einer technischen Spezifikation und/oder Positionierung und/oder Auswahl von Komponenten bei der Anlagenplanung umfassen. Der Kontextbezug auf Kriterien wie branchenspezifische Anforderungen, Umgebungsbedingungen und Anwendungsszenarien gewährleistet, dass die Anlagenplanung für den jeweiligen Einsatzbereich optimiert wird. Dies führt zu einer verbesserten Planungskompetenz in komplexen Umgebungen und unterstützt somit die Erstellung von Plänen, die den spezifischen Bedingungen gerecht werden. Zusätzlich wird durch die vorgeschlagene alternative Planungsoption eine hohe Anpassungsfähigkeit an veränderte Rahmenbedingungen ermöglicht, indem sie auf Basis der Benutzereingabe und des Kontextes einen angepassten konkretisierten Anlagenplan generiert.

Die Benutzereingabe kann bspw. in Form von natürlich gesprochener Sprache oder Text über die Benutzerschnittstelle der Softwareplattform empfangen werden. Dies kann den Vorteil haben, dass die Benutzerfreundlichkeit der Software verbessert wird, da die Benutzer nicht mehr gezwungen sind, spezifische Befehle oder Schreibweisen zu erlernen, um mit der Software zu interagieren. Es ist außerdem möglich, dass die Softwareplattform durch die Verwendung von maschinellem Lernen und künstlicher Intelligenz in der Lage ist, die Benutzereingaben zu interpretieren und zu verstehen, selbst wenn die Eingabe unvollständig oder unklar ist.

Ferner kann es im Rahmen der Erfindung vorgesehen sein, dass die Antwort dadurch die Erweiterung der Anlagenplanung spezifiziert, dass sie über eine Planungsoption neue Komponenten und/oder Subsysteme zur Integration in die bestehende Anlagenplanung spezifiziert, vorzugsweise basierend auf der verarbeiteten Benutzereingabe und dem zugeordneten Kontext. Auf diese Weise wird durch die Erfindung eine Möglichkeit geschaffen, Anlagen zumindest teilweise automatisiert zu erweitern. Dies ermöglicht eine effizientere und schnellere Integration von Änderungen und Erweiterungen in bestehende Systeme.

Gemäß einem weiteren Vorteil kann vorgesehen sein, dass die Antwort dadurch die Bewertung zumindest eines Teils der Anlagenplanung spezifiziert, dass zumindest ein durch den zugeordneten Kontext spezifizierter Teil der Anlagenplanung auf Basis von Kriterien, vorzugsweise für einen optimalen Betrieb der Anlage, analysiert wird. Weiter kann die Antwort einen Bericht umfassen, der potenzielle Verbesserungen und/oder Alternativen und/oder Modifikationen aufzeigt, die an der Anlagenplanung vorzunehmen sind, um die Kriterien zu erfüllen. Damit wird die Möglichkeit geschaffen, dass die Antwort auf spezifische Fragen zur Anlagenplanung nicht nur allgemein gehalten ist, sondern auch kontextbezogen und zielgerichtet für die spezifische Anlagenplanung ist. Die durch die Antwort spezifizierten Vorschläge können sich auf verschiedene Kriterien beziehen, wie zum Beispiel die Effizienzsteigerung, Aufwand- bzw. /Kostensenkungen oder Umweltaspekte.

Ein weiterer Vorteil kann im Rahmen der Erfindung erzielt werden, wenn die Benutzerschnittstelle eine Visualisierungskomponente zur Anzeige der Anlagenplanung und zur Ausgabe der Antwort aufweist und vorzugsweise dem Benutzer über die Benutzereingabe die Interaktion mit dem Assistenzmodul durch Texteingaben und/oder Toucheingaben und/oder Gesten und/oder Sprachbefehle ermöglicht. Daher kann die Benutzerschnittstelle bspw. eine visuelle Komponente aufweisen, die den Planungsprozess der Anlage in Echtzeit darstellt. Diese Visualisierung erleichtert es dem Nutzer, die Auswirkungen seiner Entscheidungen und Änderungen direkt zu sehen, was zu einer effizienteren und präziseren Planung führt. Zusätzlich ermöglicht die Benutzerschnittstelle ggf. eine interaktive Kommunikation mit dem Assistenzmodul durch Text- oder Sprachbefehle sowie durch Touch- oder Gestenerkennung, was den Arbeitsablauf weiter vereinfacht und beschleunigt.

Des Weiteren ist es denkbar, dass der Kontext auf der Basis einer Auswahl des Benutzers in der Anlagenplanung ermittelt wird, wobei vorzugsweise die Auswahl zumindest einen Teil der industriellen Anlage spezifiziert, wobei bevorzugt zum Ermitteln des Kontextes ein Standort und/oder ein Typ und/oder ein Zustand und/oder wenigstens ein Umweltfaktor und/oder eine Anwendung des spezifizierten Teils der Anlage berücksichtigt wird. Der Benutzer kann bspw. durch seine Auswahl über die Benutzereingabe einen Teil der industriellen Anlage spezifizieren, und basierend auf dieser Auswahl kann der Kontext angepasst werden. Dieser Kontext berücksichtigt bspw. Faktoren wie Standort, Typ, Zustand, Umweltbedingungen oder Anwendungsbereich des ausgewählten Teils der Anlage, um die Anlagenplanung automatisiert zu verbessern. Durch diesen automatisierbaren und flexiblen Ansatz lassen sich verschiedene industrielle Anlagen und -szenarien effizient abdecken.

Weiter ist es denkbar, dass das Verfahren umfasst (bevorzugt zumindest teilweise als Teil der Verarbeitung der Benutzereingabe und insbesondere der Berücksichtigung des Kontextes): Bereitstellen einer Kennzeichnung, vorzugsweise einer eindeutigen oder eineindeutigen Kennzeichnung, einer jeweiligen Komponente für die Anlage in der Anlagenplanung, vorzugsweise in einem Modell, bevorzugt 3D-Modell der Anlagenplanung. Die jeweilige Komponente kann somit eine geplante Komponente sein, die in der Anlagenplanung zunächst nur generisch, also insbesondere gattungsgemäß, spezifiziert ist.

Die jeweilige Kennzeichnung kann eine zumindest eindeutige und vorzugsweise eineindeutige Bezeichnung sein. D.h. insbesondere, dass sie die Komponente, der sie zugeordnet ist, zumindest eindeutig (ggf. auch eineindeutig) bezeichnet. Die Bezeichnung kann sich als Identifikator durch den gesamten Planungsprozess ziehen.

Weiter kann die jeweilige Kennzeichnung eine zumindest eindeutige und vorzugsweise eineindeutige Verbindung zu der ihr zugeordneten generischen Komponente im Anlagenplan und vorzugsweise Modell, bevorzugt 3D-Modell, aufweisen. Die Planung kann dadurch nachvollziehbar gemacht werden, indem die zumindest eindeutige Verbindung durch die zugeteilte, zumindest eindeutige Bezeichnung dokumentiert wird.

Zudem kann das Verfahren umfassen (bevorzugt zumindest teilweise als Teil der Verarbeitung der Benutzereingabe und insbesondere der Berücksichtigung des Kontextes): Erzeugen wenigstens eines konkretisierten Anlagenplans, vorzugsweise umfassend einen Schaltplan, bevorzugt elektrischen Schaltplan, welcher die Komponenten technisch näher spezifiziert, vorzugsweise konkretisiert, insbesondere hinsichtlich einer Betriebsmittelkennzeichnung und/oder Artikelkennzeichnung und/oder Herstellerkennzeichnung und/oder Serienkennzeichnung. Dabei kann der wenigstens eine konkretisierte Anlagenplan auf Basis der Benutzereingabe und unter Berücksichtigung des Kontextes erzeugt werden. Dies ermöglicht es, die Konkretisierung der Komponenten derart vorzunehmen, dass die näher spezifizierten Komponenten den Anforderungen entsprechen, die sich aus dem Kontext und der Benutzereingabe ergeben. Mit anderen Worten können die technisch näher spezifizieren bzw. konkretisierten Komponenten so ausgewählt werden, dass sie a) der in der Anlagenplanung spezifizierten Gattung entsprechen und b) Anforderungen aus dem Kontext und/oder der Benutzereingabe gerecht werden. Für die Auswahl kann bspw. eine Schnittstelle zu einer Komponenten- und/oder Bestelldatenbank bestehen.

Vorteilhafterweise kann der konkretisierte Anlagenplan, ggf. zur zumindest eindeutigen, Identifizierung der jeweiligen Komponente die Kennzeichnung zuordnen, sodass die Kennzeichnungen für die Komponenten als Identifikatoren im weiteren Planungsprozess bereitstehen.

Ferner ist es möglich, dass die Anlagenplanung, vorzugsweise das Modell, bevorzugt 3D-Modell, zur Planung der Anlage die Komponenten zunächst nur generisch spezifiziert, und dass das Bereitstellen der jeweiligen Kennzeichnung als eine Zuordnung der Kennzeichnungen zu den generisch, vorzugsweise nur gattungsgemäß, spezifizierten Komponenten in der Anlagenplanung erfolgt. Weiter kann durch das Erzeugen des wenigstens einen konkretisierten Anlagenplans die generisch spezifizierten Komponenten derart konkretisiert werden, dass sie Anforderungen entsprechen, die sich aus dem Kontext und der Benutzereingabe ergeben. Dies hat den Vorteil, dass auf Basis einer Vorlage wie die Anlagenplanung der Planungsprozess automatisiert fortgesetzt werden kann. Zur Gewährleistung der Nachverfolgbarkeit können die Kennzeichnungen für die Komponenten als Identifikatoren im weiteren Planungsprozess weiterhin bereitgestellt werden.

Ferner ist es optional vorgesehen, dass der Kontext auf der Basis einer Ermittlung eines realen Standorts des Benutzers in der industriellen Anlage ermittelt wird. Das Assistenzmodul kann dabei in der Antwort ggf. spezifische Informationen oder Anweisungen basierend auf dem aktuellen Standort des Benutzers liefern, was die Effektivität der Interaktion und die Relevanz der Antworten erhöht. Zusätzlich können durch diese Funktionalität auch georeferenzierte Daten für die Planung und den Betrieb der Anlage genutzt werden, was zu verbesserten Planungsoptionen führen kann. Die Ermittlung des Standorts kann dabei ggf. automatisch und ohne zusätzliche Benutzereingaben erfolgen. Zusätzlich ermöglicht diese Art von Kontexterfassung eine bessere Integration von Daten aus verschiedenen Quellen, wie z.B. Sensor- oder Gerätedaten, um einen umfassenderen Überblick über die industrielle Anlage zu erhalten.

Gemäß einem weiteren Vorteil kann vorgesehen sein, dass die Verarbeitung der Benutzereingabe eine semantische Analyse der empfangenen Benutzereingabe umfasst, wobei vorzugsweise das Assistenzmodul Techniken der Verarbeitung natürlicher Sprache und des maschinellen Lernens verwendet, um die Benutzereingabe zu analysieren. Dies ermöglicht es, die Eingaben des Nutzers in einem Kontext zu interpretieren und daraus Rückschlüsse auf den tatsächlichen Absichtswillen des Benutzers zu ziehen. Durch die Verwendung von Methoden der natürlichen Sprachverarbeitung und des maschinellen Lernens kann das Assistenzmodul die Eingabe effektiv analysieren, was zu einer verbesserten Interaktion mit dem Benutzer führt.

Des Weiteren ist es denkbar, dass das Assistenzmodul dafür ausgeführt, vorzugsweise trainiert, ist, automatisch zumindest Teile der Anlagenplanung, vorzugsweise Teile eines Schaltplans und/oder einer Topologie, für die industrielle Anlage zu erzeugen und/oder anzupassen und/oder zu interpretieren.

Ferner kann die Antwort hierzu vorzugsweise umfassen:
- wenigstens einen Vorschlag für einen ersten oder alternativen Entwurf für die Anlagenplanung, und/oder
- wenigstens einen Vorschlag für eine Änderung der Anlagenplanung, um die industrielle Anlage mit verbesserter Systemleistung und/oder -effizienz und/oder dergleichen zu betreiben, und/oder
- wenigstens eine Anpassung einer Parametrisierung der industriellen Anlage,
- eine Erzeugung von neuen Verbindungen und/oder Schnittstellen zwischen Komponenten der Anlage.

Damit wird der Vorteil erzielt, dass die Entwicklung und Anpassung von industriellen Anlagenplanungen effizienter gestaltet werden kann. Das Assistenzmodul, insbesondere in der Form eines LLM-Sprachassistenten, ermöglicht es - bspw. durch automatisierte Textverarbeitung und Interpretation -, schnell auf individuelle Bedürfnisse zu reagieren und alternative Entwurfsoptionen oder Anpassungen vorzuschlagen. Dies spart Zeit und Ressourcen bei der Planung und ermöglicht eine optimale Ausrichtung auf die spezifischen Anforderungen des jeweiligen Industriezweigs. Zusätzlich kann durch die Erkennung von Umwelteinflüssen und branchenspezifischen Bedingungen dazu beigetragen werden, dass die Planung robust und effizient ist. Der wenigstens eine Vorschlag für eine Änderung der Anlagenplanung kann ebenfalls dazu dienen, die Anlage derart zu modifizieren, dass sie mit besserer Verfügbarkeit und/oder logistischer Verbesserung und/oder verbesserter Systemleistung und/oder -effizienz und/oder angepasster Systemart, z. B. nach aktiven oder passiven Verteilern und/oder nach einer bestimmten Art der Feldbustechnologie und/oder einem bestimmten technischen Lösungsansatz betrieben werden kann.

Beispielsweise kann es vorgesehen sein, dass bei der Verarbeitung Anlagendaten von einem Modell, vorzugsweise 3D Modell, und/oder digitalen Zwilling der industriellen Anlage abgerufen werden, um die Antwort zu genieren und vorzugsweise den Kontext zu ermitteln. Auf diese Weise wird durch die Erfindung eine Möglichkeit geschaffen, bei der Anlagendaten aus einem Modell bzw. digitalen Zwilling einer industriellen Anlage für die Generierung der Antwort(en) und vorzugsweise zur Bestimmung des Kontextes herangezogen werden können. Die Verwendung eines digitalen Zwillings erlaubt eine dynamische Anpassung der Antworten an sich ändernde Bedingungen und gewährleistet somit eine hohe Genauigkeit. Durch die Verfügbarkeit einer virtuellen Kopie der Anlage kann ein besseres Verständnis des Systemverhaltens erreicht werden, wodurch die Qualität der Antwort erhöht wird. Darüber hinaus bietet der digitale Zwilling die Möglichkeit, verschiedene Szenarios zu simulieren und so eine umfassende Analyse des Systemverhaltens durchzuführen. Dies kann dazu beitragen, dass die Anlage in Zukunft besser an zukünftige Anforderungen angepasst werden kann.

Gemäß einem weiteren Vorteil kann vorgesehen sein, dass die Benutzereingabe wenigstens eine Frage zu der industriellen Anlage und/oder der Anlagenplanung umfasst, und das Assistenzmodul dazu ausgeführt ist, automatisch die wenigstens eine Frage zu beantworten und hierzu vorzugsweise wenigstens eine Gerätespezifikation und/oder Betriebsbedingung und/oder eine Wartungshistorie über die Antwort und/oder eine Rückfrage ausgibt. Dadurch kann das Assistenzmodul durch die Integration eines Frage-Antwort-Systems eine iterative Anpassung und/oder Optimierung des Planungsprozesses und/oder der Informationsbasis für die Verarbeitung ermöglichen. Dabei können, sofern die Informationsbasis noch nicht ausreichend ist, ein oder mehrere automatisierte Rückfragen vorgesehen sein, um die fehlenden Informationen zu ermitteln. Die Ausgabe der Rückfrage kann somit erfolgen, um den Kontext weiter zu spezifizieren und/oder den Kontext zu ergänzen. Die Rückfragen können auch wiederholt gestellt werden, bis der Kontext ausreichend spezifiziert wurde und alle Informationen vorliegen, z. B. auch hinsichtlich einer Sensorauswahl oder einer Komponentenauswahl. Das Assistenzmodul kann automatisch die Antworten und/oder Rückfragen generieren, indem bspw. relevante Informationen aus der Gerätespezifikation, den Betriebsbedingungen und/oder der Wartungshistorie abgerufen werden. Dies spart dem Benutzer Zeit bei der Suche nach Informationen und verbessert die Effizienz des Planungsprozesses.

Weiter ist es denkbar, dass das Assistenzmodul dazu ausgeführt ist, als Reaktion auf die Benutzereingabe eine Rückfrage an den Benutzer auszugeben, insbesondere eine Rückfrage zu der industriellen Anlage und/oder der Anlagenplanung und/oder zu der Frage der Benutzereingabe, um die für die Antwort benötigten Informationen zu erlangen. Dies hat den Vorteil, dass das Assistenzmodul selbst fehlende oder vorteilhafte Informationen erkennt und zur Verbesserung der Antwort die Informationen automatisiert einholen kann.

Ferner kann im Rahmen der Erfindung vorgesehen sein, dass das Assistenzmodul dafür ausgeführt ist, vorzugsweise trainiert ist, automatisch den Benutzer über die Antwort über mögliche Fehler oder Unstimmigkeiten in der Anlagenplanung zu informieren, wobei hierzu vorzugsweise über die Verarbeitung die Benutzereingabe analysiert wird, um potenzielle Fehler oder Inkonsistenzen in einem Schaltplan zu identifizieren. Durch die Analyse der Benutzereingabe und das Erkennen von potenziellen Problemen kann das Assistenzmodul proaktiv auf Unstimmigkeiten hinweisen, was die Qualität des Planungsprozesses verbessert und mögliche Fehler frühzeitig identifiziert.

Zudem ist im Rahmen der Erfindung denkbar, dass das Assistenzmodul dafür ausgeführt ist, dass es automatisch Nutzungsmuster des Benutzers verfolgt, indem es die Benutzereingabe und historische Benutzereingaben analysiert und Benutzerpräferenzen für bestimmte Befehle und Funktionen lernt, wodurch vorzugsweise personalisierte Vorschläge auf der Basis der Analyse erzeugt werden. Diese Funktion ermöglicht es dem Assistenzmodul, die Interaktion mit dem Nutzer zu optimieren und effizientere Arbeitsabläufe zu unterstützen.

Ebenfalls Gegenstand der Erfindung ist eine Vorrichtung zur Datenverarbeitung, umfassend Mittel zur Ausführung der Schritte des erfindungsgemäßen Verfahrens. Damit bringt die erfindungsgemäße Vorrichtung zur Datenverarbeitung die gleichen Vorteile mit sich, wie sie ausführlich mit Bezug auf ein erfindungsgemäßes Verfahren beschrieben worden sind.

Ebenfalls Gegenstand der Erfindung ist ein Computerprogramm, insbesondere Computerprogrammprodukt, umfassend Befehle, die bei der Ausführung des Computerprogrammes durch einen Computer diesen veranlassen, das erfindungsgemäße Verfahren auszuführen. Damit bringt das erfindungsgemäße Computerprogramm die gleichen Vorteile mit sich, wie sie ausführlich mit Bezug auf ein erfindungsgemäßes Verfahren beschrieben worden sind. Das Computerprogramm kann ferner zumindest teilweise nicht-flüchtig und/oder als Software zum Download und/oder als Cloud-Service und/oder als ausführbares Programm und/oder als Konfigurationsdatei und/oder als Programmbibliothek und/oder als Quelltext und/oder in kompilierter und/oder verschlüsselter und/oder komprimierter Form und/oder in einer Kombination davon vorliegen.

Als der Computer kann eine Datenverarbeitungsvorrichtung, vorzugsweise die erfindungsgemäße Vorrichtung zur Datenverarbeitung, vorgesehen sein.

Die erfindungsgemäße Vorrichtung zur Datenverarbeitung und vorzugsweise der Computer kann dazu ausgebildet sein, das erfindungsgemäße Computerprogramm auszuführen. Hierzu kann die erfindungsgemäße Vorrichtung zur Datenverarbeitung wenigstens einen Prozessor aufweisen. Auch kann ein nicht-flüchtiger Datenspeicher vorgesehen sein, in welchem das Computerprogramm hinterlegt und von welchem das Computerprogramm durch den Prozessor zur Ausführung ausgelesen werden kann.

Ebenfalls ist es denkbar, dass die erfindungsgemäße Vorrichtung zur Datenverarbeitung zumindest einen integrierten Schaltkreis wie einen Mikroprozessor oder eine Anwendungsspezifische integrierte Schaltung (ASIC) oder ein Anwendungsspezifisches Standardprodukt (ASSP) oder einen digitalen Signalprozessor (DSP) oder einen Field Programmable Gate Array (FPGA) oder dergleichen umfasst. Die erfindungsgemäße Vorrichtung zur Datenverarbeitung kann ferner wenigstens eine Schnittstelle zum Datenaustausch, z. B. eine Ethernet-Schnittstelle oder eine Schnittstelle für LAN (Local Area Network) oder WLAN (Wireless Local Area Network) oder System-on-a-Chip (SoC) oder eine andere Funkschnittstelle wie bspw. zur Bluetooth- oder Nahfeldkommunikation (NFC) aufweisen. Ferner kann die erfindungsgemäße Vorrichtung zur Datenverarbeitung als ein oder mehrere Steuergeräte, d. h. auch als ein System aus Steuergeräten, ausgeführt sein. Die erfindungsgemäße Vorrichtung zur Datenverarbeitung kann vollständig oder teilweise auch in einer Cloud und/oder als ein Server vorgesehen sein, um über die Schnittstelle die Datenverarbeitung für eine lokale Anwendung zur Verfügung zu stellen. Entsprechend kann die erfindungsgemäße Vorrichtung zur Datenverarbeitung auch als ein verteiltes System ausgebildet sein. Auch ist es möglich, dass die erfindungsgemäße Vorrichtung zur Datenverarbeitung als ein mobiles Gerät, wie ein Smartphone, ausgeführt ist.

Ebenfalls Gegenstand der Erfindung kann ein computerlesbares Speichermedium sein, welches das erfindungsgemäße Computerprogramm umfasst. Das Speichermedium ist bspw. als ein Datenspeicher wie eine Festplatte und/oder ein nicht-flüchtiger Speicher und/oder eine Speicherkarte ausgebildet. Das Speichermedium kann z. B. in den Computer und/oder in die erfindungsgemäße Vorrichtung zur Datenverarbeitung integriert sein.

Darüber hinaus kann das erfindungsgemäße Verfahren auch als ein computerimplementiertes Verfahren ausgeführt sein. Alternativ oder zusätzlich können jeder einzelne oder sämtliche der offenbarten Verfahrensschritte optional computer-implementiert sein und/oder automatisiert durchgeführt werden.

Weitere Vorteile, Merkmale und Einzelheiten der Erfindung ergeben sich aus der nachfolgenden Beschreibung, in der unter Bezugnahme auf die Zeichnungen Ausführungsbeispiele der Erfindung im Einzelnen beschrieben sind. Dabei können die in den Ansprüchen und in der Beschreibung erwähnten Merkmale jeweils einzeln für sich oder in beliebiger Kombination erfindungswesentlich sein. Es zeigen:
- Fig. 1: eine schematische Darstellung einer Softwareplattform gemäß Ausführungsvarianten der Erfindung.
- Fig. 2: eine schematische Darstellung einer Anlagenplanung.
- Fig. 3: eine schematische Darstellung eines Verfahrens gemäß Ausführungsvarianten der Erfindung.
- Fig. 4: eine schematische Darstellung eines Computerprogramms und einer Vorrichtung gemäß Ausführungsvarianten der Erfindung.

In den nachfolgenden Figuren werden für die gleichen technischen Merkmale auch von unterschiedlichen Ausführungsbeispielen die identischen Bezugszeichen verwendet.

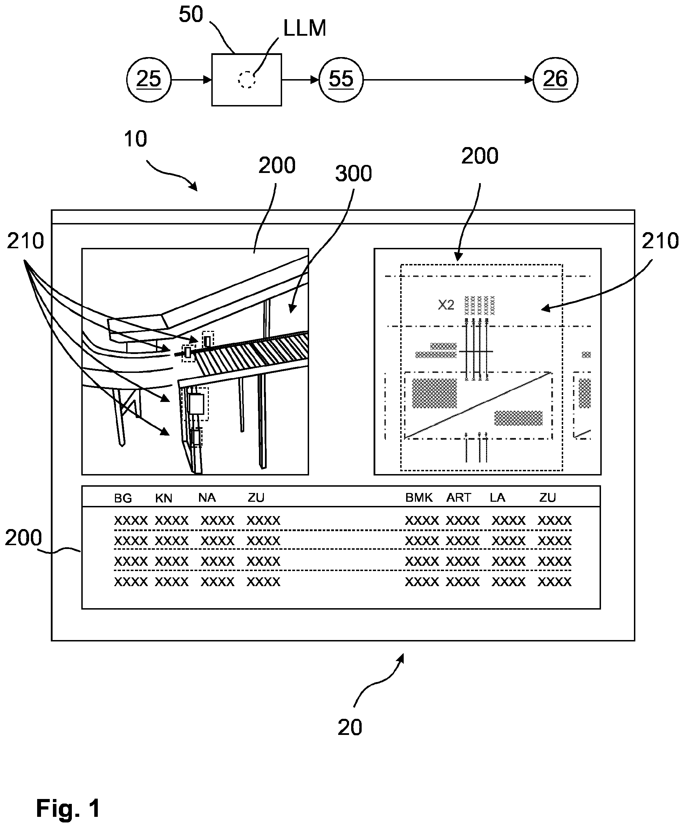

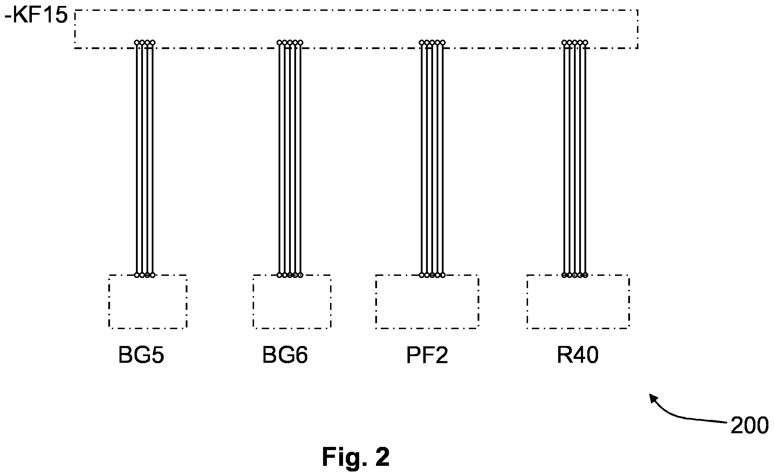

Fig. 1 zeigt eine beispielhafte Softwareplattform, welche zur Planung, Bewertung und Optimierung von industriellen Anlagen eingesetzt werden kann. Es werden dabei zwei unterschiedliche Darstellungen bereitgestellt, welche bspw. eine mechanische Darstellung (MCAD) und eine elektrische Darstellung (z. B. einen in Fig. 2 mit weiteren Einzelheiten dargestellten elektrischen Schaltplan) umfassen können. Der Schaltplan kann bspw. Betriebsmittelkennzeichen (BMK) darstellen, durch welche die einzelnen Komponenten der Anlage identifiziert werden können. Durch diese Darstellungsmöglichkeiten ermöglicht die Softwareplattform eine einfache Zuordnung, effizientere Planung und ggf. auch eine schnelle Fehleranalyse und -behebung, was zu einer erheblichen Effizienzsteigerung bei der Planung führt.

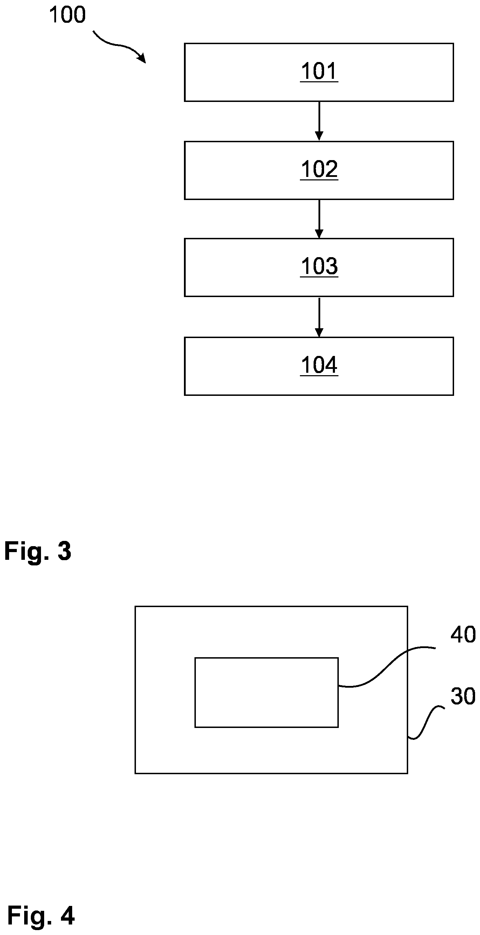

Fig. 3 veranschaulicht gemäß Ausführungsbeispielen der Erfindung ein Verfahren 100 zur computer-gestützten Erstellung einer Planung für eine industrielle Anlage 300 mittels einer Softwareplattform 10. Dabei ist es vorgesehen, dass zunächst eine Benutzereingabe 25 über wenigstens eine Benutzerschnittstelle 20 der Softwareplattform 10 empfangen werden kann. Anschließend kann gemäß einem zweiten Verfahrensschritt 102 eine Zuordnung zwischen der Benutzereingabe 25 und einem Kontext 210 einer Anlagenplanung 200 vorgenommen werden. In der Anlagenplanung 200 kann dabei zumindest ein Teil der industriellen Anlage 300 geplant werden.

Sodann kann gemäß einem dritten Verfahrensschritt die Benutzereingabe 25 durch ein Assistenzmodul 50 verarbeitet werden, um auf Basis der Benutzereingabe 25 und unter Berücksichtigung des zugeordneten Kontextes 210 eine Antwort 55 zu generieren, die eine Gestaltung, Umgestaltung, Erweiterung oder Bewertung der Anlagenplanung 200 spezifiziert. Diese Antwort 55 kann dann gemäß einem vierten Verfahrensschritt 104 über mindestens eine Benutzerschnittstelle 20 an den Benutzer über eine Ausgabe 26 bereitgestellt werden.

Das Assistenzmodul 50 kann ein Large Language Model LLM umfassen, welches dafür ausgeführt ist, mittels eines vortrainierten, tiefen neuronalen Netzwerks kontextbezogene Antworten 55 basierend auf der Benutzereingabe 25 zu generieren. Dies kann den Vorteil haben, dass die Benutzer eine umfassende und relevante Antwort erhalten, ohne dass sie weitere Eingaben tätigen müssen.

Weiter ist es möglich, dass die Antwort 55 eine Planungsoption, vorzugsweise erste oder alternative Planungsoption, vorschlägt, die wenigstens einem Kriterium, insbesondere wenigstens einer Bedingung und/oder wenigstens einer Einschränkung und/oder wenigstens einem Umstand und/oder wenigstens einem Bedürfnis, entspricht, welches durch die Benutzereingabe 25 und/oder durch den Kontext 210 spezifiziert wird. Die vorgeschlagene Planungsoption ermöglicht eine optimierte Anpassung an die individuellen Bedürfnisse des Benutzers, indem sie auf die spezifischen Eingaben und den Kontext abgestimmt ist. Dies führt zu einer erhöhten Effizienz und Genauigkeit der Ergebnisse, da die Planungsoption sich an die konkreten Anforderungen anpasst. Durch die Berücksichtigung von Bedingungen, Einschränkungen und Umständen kann die vorgeschlagene Planungsoption auch in komplexen Situationen effektiv eingesetzt werden.

Die Antwort 55 kann die Gestaltung, insbesondere Neugestaltung und/oder einen Erstvorschlag für die Gestaltung, zumindest eines Teils der Anlagenplanung 200 spezifizieren. Sie bietet somit auf Basis der verarbeiteten Benutzereingabe 25 und des zugeordneten Kontextes 210 eine Planungsoption, die eine Anpassung einer technischen Spezifikation und/oder Positionierung und/oder Auswahl von Komponenten bei der Anlagenplanung 200 bereitstellt. Die Antwort 55 ermöglicht daher die Umgestaltung, Erweiterung oder Bewertung zumindest eines Teils der Anlagenplanung 200.

Weiter kann das Verfahren 100 zur Planung, Bewertung und Optimierung von industriellen Anlagen eine in Fig. 1 dargestellte Benutzerschnittstelle 20 bereitstellen, die eine Visualisierungskomponente aufweist. Durch die Visualisierungskomponente ist es bspw. möglich, die Anlagenplanung 200 anzuzeigen und die Antwort 55 auszugeben. Die Benutzerschnittstelle 20 ermöglicht ferner durch einen Benutzerinput 25, wie Texteingaben, Toucheingaben, Gesten oder Sprachbefehle, eine Interaktion mit einem Assistenzmodul 50.

Der Kontext 210 kann ferner auf der Basis einer Auswahl des Benutzers in der Anlagenplanung 200 ermittelt werden. Dabei kann die Auswahl zumindest einen Teil der industriellen Anlage 300 spezifizieren. Weiter kann zum Ermitteln des Kontextes 210 ein Standort und/oder ein Typ und/oder ein Zustand und/oder Umweltfaktoren und/oder eine Anwendung des spezifizierten Teils der Anlage 300 berücksichtigt werden.

In Fig. 4 ist ferner ein Computerprogramm 40 und eine Vorrichtung 30 zur Datenverarbeitung gemäß Ausführungsvarianten der Erfindung dargestellt.

Die voranstehende Erläuterung der Ausführungsformen beschreibt die vorliegende Erfindung ausschließlich im Rahmen von Beispielen. Selbstverständlich können einzelne Merkmale der Ausführungsformen, sofern technisch sinnvoll, frei miteinander kombiniert werden, ohne den Rahmen der vorliegenden Erfindung zu verlassen.

### Bezugszeichenliste

- 10: Softwareplattform

- 20: Benutzerschnittstelle
- 25: Benutzereingabe
- 26: Ausgabe

- 30: Computer

- 40: Computerprogramm

- 50: Assistenzmodul
- 55: Antwort

- 100: Verfahren

- 200: Anlagenplanung
- 210: Kontext

- 300: Anlage

- LLM: Large Language Model

## Patentansprüche

1. Verfahren (100) zur computer-gestützten Erstellung einer Planung für eine industrielle Anlage (300) mittels einer Softwareplattform (10), aufweisend:
- Empfangen (101) einer Benutzereingabe (25) über wenigstens eine Benutzerschnittstelle (20) der Softwareplattform (10),
- Zuordnen (102) der Benutzereingabe (25) zu einem Kontext (210) einer Anlagenplanung (200), durch welche zumindest ein Teil der industriellen Anlage (300) geplant wird,
- Verarbeiten (103) der Benutzereingabe (25) durch ein Assistenzmodul (50), wobei eine Antwort (55) des Assistenzmoduls (50) auf Basis der Benutzereingabe (25) und unter Berücksichtigung des Kontextes (210) generiert wird, wobei die Antwort (55) eine Gestaltung und/oder eine Umgestaltung und/oder eine Erweiterung und/oder eine Bewertung zumindest eines Teils der Anlagenplanung (200) spezifiziert,
- Initiieren (104) einer Ausgabe (26) der Antwort (55) an den Benutzer über die wenigstens eine Benutzerschnittstelle (20).

2. Verfahren (100) nach Anspruch 1,
**dadurch gekennzeichnet,**
**dass** das Assistenzmodul (50) ein Large Language Model (LLM) umfasst, wobei das Large Language Model (LLM) dafür ausgeführt ist, mittels eines vortrainierten, tiefen neuronalen Netzwerks kontextbezogene Antworten (55) basierend auf der Benutzereingabe (25) zu generieren.

3. Verfahren (100) nach einem der vorhergehenden Ansprüche,
**dadurch gekennzeichnet,**
**dass** die Antwort (55) eine Planungsoption, vorzugsweise erste oder alternative Planungsoption, vorschlägt, die wenigstens einem Kriterium, insbesondere wenigstens einer Bedingung und/oder wenigstens einer Einschränkung und/oder wenigstens einem Umstand und/oder wenigstens einem Bedürfnis, entspricht, welches durch die Benutzereingabe (25) und/oder durch den Kontext (210) spezifiziert wird.

4. Verfahren (100) nach einem der vorhergehenden Ansprüche,
**dadurch gekennzeichnet,**
**dass** die Antwort (55) die Gestaltung, insbesondere Neugestaltung und/oder einen Erstvorschlag für die Gestaltung, zumindest eines Teils der Anlagenplanung (200) spezifiziert, und hierzu auf Basis der verarbeiteten Benutzereingabe (25) und des Kontextes (210) eine Planungsoption vorschlägt, wobei die Planungsoption eine Anpassung einer technischen Spezifikation und/oder Positionierung und/oder Auswahl von Komponenten bei der Anlagenplanung (200) bereitstellt.

5. Verfahren (100) nach einem der vorhergehenden Ansprüche,
**dadurch gekennzeichnet,**
**dass** die Antwort (55) dadurch die Umgestaltung zumindest eines Teils der Anlagenplanung (200) spezifiziert, dass sie auf Basis der verarbeiteten Benutzereingabe (25) und des Kontextes (210) eine alternative Planungsoption vorschlägt, wobei die alternative Planungsoption eine Anpassung einer technischen Spezifikation und/oder Positionierung und/oder Auswahl von Komponenten bei der Anlagenplanung (200) umfasst.

6. Verfahren (100) nach einem der vorhergehenden Ansprüche,
**dadurch gekennzeichnet,**
**dass** die Antwort (55) dadurch die Erweiterung der Anlagenplanung (200) spezifiziert, dass sie über eine Planungsoption neue Komponenten und/oder Subsysteme zur Integration in die bestehende Anlagenplanung (200) spezifiziert, basierend auf der verarbeiteten Benutzereingabe (25) und dem Kontext (210).

7. Verfahren (100) nach einem der vorhergehenden Ansprüche,
**dadurch gekennzeichnet,**
**dass** die Antwort (55) dadurch die Bewertung zumindest eines Teils der Anlagenplanung (200) spezifiziert, dass zumindest ein durch den Kontext (210) spezifizierter Teil der Anlagenplanung (200) auf Basis von Kriterien, vorzugsweise für einen optimalen Betrieb der Anlage (300), analysiert wird, wobei die Antwort (55) einen Bericht umfasst, der potenzielle Verbesserungen und/oder Alternativen und/oder Modifikationen aufzeigt, die an der Anlagenplanung (200) vorzunehmen sind, um die Kriterien zu erfüllen.

8. Verfahren (100) nach einem der vorhergehenden Ansprüche,
**dadurch gekennzeichnet,**
**dass** die Benutzerschnittstelle (20) eine Visualisierungskomponente zur Anzeige der Anlagenplanung (200) und zur Ausgabe (26) der Antwort (55) aufweist und dem Benutzer über die Benutzereingabe (25) die Interaktion mit dem Assistenzmodul (50) durch Texteingaben und/oder Toucheingaben und/oder Gesten und/oder Sprachbefehle ermöglicht.

9. Verfahren (100) nach einem der vorhergehenden Ansprüche,
**dadurch gekennzeichnet,**
**dass** der Kontext (210) auf der Basis einer Auswahl des Benutzers in der Anlagenplanung (200) ermittelt wird, wobei die Auswahl zumindest einen Teil der industriellen Anlage (300) spezifiziert, wobei zum Ermitteln des Kontextes (210) ein Standort und/oder ein Typ und/oder ein Zustand und/oder Umweltfaktoren und/oder eine Anwendung des spezifizierten Teils der Anlage (300) berücksichtigt wird.

10. Verfahren (100) nach einem der vorhergehenden Ansprüche,
**dadurch gekennzeichnet,**
**dass** das Verfahren (100) ferner umfasst, bevorzugt zumindest teilweise als Teil der Verarbeitung (103) der Benutzereingabe und insbesondere der Berücksichtigung des Kontextes (210):
- Bereitstellen einer Kennzeichnung, vorzugsweise einer eindeutigen oder eineindeutigen Kennzeichnung, einer jeweiligen Komponente für die Anlage in der Anlagenplanung (200), vorzugsweise in einem Modell, bevorzugt 3D-Modell der Anlagenplanung (200),
- Erzeugen wenigstens eines konkretisierten Anlagenplans, vorzugsweise umfassend einen Schaltplan, welcher die Komponenten technisch näher spezifiziert, insbesondere hinsichtlich einer Betriebsmittelkennzeichnung und/oder Artikelkennzeichnung und/oder Herstellerkennzeichnung und/oder Serienkennzeichnung, wobei der wenigstens eine konkretisierte Anlagenplan auf Basis der Benutzereingabe (25) und unter Berücksichtigung des Kontextes (210) erzeugt wird, wobei der konkretisierte Anlagenplan weiterhin zur Identifizierung der jeweiligen Komponente die Kennzeichnung zuordnet, sodass die Kennzeichnungen für die Komponenten als Identifikatoren im weiteren Planungsprozess bereitstehen.

11. Verfahren (100) nach Anspruch 10,
**dadurch gekennzeichnet,**
**dass** die Anlagenplanung (200), vorzugsweise das Modell, zur Planung der Anlage die Komponenten zunächst nur generisch spezifiziert, und
**dass** das Bereitstellen der jeweiligen Kennzeichnung als eine Zuordnung der Kennzeichnungen zu den generisch, vorzugsweise nur gattungsgemäß, spezifizierten Komponenten in der Anlagenplanung (200) erfolgt, wobei durch das Erzeugen des wenigstens einen konkretisierten Anlagenplans die generisch spezifizierten Komponenten derart konkretisiert werden, dass sie Anforderungen entsprechen, die sich aus dem Kontext (210) und der Benutzereingabe (25) ergeben.

12. Verfahren (100) nach einem der vorhergehenden Ansprüche,
**dadurch gekennzeichnet,**
**dass** die Verarbeitung (103) der Benutzereingabe (25) eine semantische Analyse der empfangenen Benutzereingabe (25) umfasst, wobei vorzugsweise das Assistenzmodul (50) Techniken der Verarbeitung natürlicher Sprache und des maschinellen Lernens verwendet, um die Benutzereingabe (25) zu analysieren.

13. Verfahren (100) nach einem der vorhergehenden Ansprüche,
**dadurch gekennzeichnet,**
**dass** das Assistenzmodul (50) dafür ausgeführt, vorzugsweise trainiert, ist, automatisch zumindest Teile der Anlagenplanung (200), vorzugsweise Teile eines Schaltplans und/oder einer Topologie, für die industrielle Anlage (300) zu erzeugen und/oder anzupassen und/oder zu interpretieren, wobei die Antwort (55) hierzu vorzugsweise umfasst:
- wenigstens einen Vorschlag für einen ersten oder alternativen Entwurf für die Anlagenplanung (200), und/oder
- wenigstens einen Vorschlag für eine Änderung der Anlagenplanung (200), um die industrielle Anlage (300) mit verbesserter Systemleistung und/oder -effizienz und/oder dergleichen zu betreiben, und/oder
- wenigstens eine Anpassung einer Parametrisierung der industriellen Anlage (300),
- eine Erzeugung von neuen Verbindungen und/oder Schnittstellen zwischen Komponenten der Anlage (300).

14. Verfahren (100) nach einem der vorhergehenden Ansprüche,
**dadurch gekennzeichnet,**
**dass** bei der Verarbeitung (103) Anlagendaten von einem Modell und/oder digitalen Zwilling der industriellen Anlage (300) abgerufen werden, um die Antwort (55) zu genieren und vorzugsweise den Kontext (210) zu ermitteln.

15. Verfahren (100) nach einem der vorhergehenden Ansprüche,
**dadurch gekennzeichnet,**
**dass** die Benutzereingabe (25) wenigstens eine Frage zu der industriellen Anlage (300) und/oder der Anlagenplanung (200) umfasst, und das Assistenzmodul (50) dazu ausgeführt ist, automatisch die wenigstens eine Frage zu beantworten und hierzu vorzugsweise wenigstens eine Gerätespezifikation und/oder
Betriebsbedingung und/oder eine Wartungshistorie über die Antwort (55) und/oder eine Rückfrage ausgibt, und/oder
**dass** das Assistenzmodul (50) dazu ausgeführt ist, als Reaktion auf die Benutzereingabe (25) eine Rückfrage an den Benutzer auszugeben, insbesondere eine Rückfrage zu der industriellen Anlage (300) und/oder der Anlagenplanung (200) und/oder zu der Frage der Benutzereingabe (25), um die für die Antwort (55) benötigten Informationen zu erlangen.

16. Verfahren (100) nach einem der vorhergehenden Ansprüche,
**dadurch gekennzeichnet,**
**dass** das Assistenzmodul (50) dafür ausgeführt ist, vorzugsweise trainiert ist, automatisch den Benutzer über die Antwort (55) über mögliche Fehler oder Unstimmigkeiten in der Anlagenplanung (200) zu informieren, wobei hierzu über die Verarbeitung (103) die Benutzereingabe analysiert wird, um potenzielle Fehler oder Inkonsistenzen in einem Schaltplan zu identifizieren.

17. Verfahren (100) nach einem der vorhergehenden Ansprüche,
**dadurch gekennzeichnet,**
**dass** das Assistenzmodul (50) dafür ausgeführt ist, dass es automatisch Nutzungsmuster des Benutzers verfolgt, indem es die Benutzereingabe (25) und historische Benutzereingaben (25) analysiert und Benutzerpräferenzen für bestimmte Befehle und Funktionen lernt, wodurch personalisierte Vorschläge auf der Basis der Analyse erzeugt werden.

18. Computerprogramm (40), umfassend Befehle, die bei der Ausführung des Computerprogramms (40) durch einen Computer (30) diesen veranlassen, das Verfahren nach einem der vorhergehenden Ansprüche auszuführen.

19. Vorrichtung (30) zur Datenverarbeitung, die eingerichtet ist, das Verfahren (100) nach einem der Ansprüche 1 bis 17 auszuführen.
